# EUROPÄISCHE PATENTANMELDUNG

(11) **EP 4 697 870 A1**
(43) Veröffentlichungstag der Anmeldung: **18.02.2026**
(21) Anmeldenummer: 24194771.2
(22) Anmeldetag: 15.08.2024
(51) Int. Cl.: H05K 5/06, H05K 7/14

(54) **VERFAHREN ZUR HERSTELLUNG EINES AUTOMATISIERUNGSGERÄTES UND AUTOMATISIERUNGSGERÄT**

(71) Anmelder: Siemens Aktiengesellschaft, 80333 München (DE)
(72) Erfinder: Ehinger, Matthias, 76149 Karlsruhe (DE)
(74) Vertreter: Siemens Patent Attorneys

(57) **Zusammenfassung**

Die Erfindung betrifft ein Verfahren zum Herstellen eines Automatisierungsgerätes (1) für eine technische Anlage, insbesondere Fertigungs- oder Prozessanlage, umfassend:
a) Vorsehen eines ersten Teils (2) einer Umhausung für das Automatisierungsgerät (1), wobei der erste Teil (2) derart ausgebildet ist, dass ein erster Teilbereich (4) und ein zweiter Teilbereich (5) erzeugt ist,
b) Anordnen einer Elektronikbaugruppe (3) in dem ersten Teil (2) der Umhausung, wobei die Elektronikbaugruppe (3) in dem ersten Teilbereich (4) und in dem zweiten Teilbereich (5) der Umhausung angeordnet wird, und wobei die Elektronikbaugruppe (3) nach dem Anordnen in dem zweiten Teilbereich (5) Kommunikationsschnittstellen (6) aufweist, die für eine Kommunikation des Automatisierungsgerätes (1) mit externen Kommunikationspartnern vorgesehen und ausgebildet sind,
c) Vorsehen eines Trennelementes (8) zwischen dem ersten Teilbereich (4) und dem zweiten Teilbereich (5) des ersten Teils (2) der Umhausung,
d) Vergießen des ersten Teilbereichs (4) des ersten Teils (2) der Umhausung mit einer elektrisch isolierenden Vergussmasse (14), wobei das Trennelement (8) eine horizontale Ausbreitung, orthogonal zu der Schwerkraft, der Vergussmasse (14) verhindert,
e) Vorsehen eines zweiten Teils (15) der Umhausung für das Automatisierungsgerät (1) und Verbinden des zweiten Teils (15) der Umhausung mit dem ersten Teil (2) der Umhausung, um die vollständige Umhausung für das Automatisierungsgerät (1) zu erzeugen.

## Beschreibung

Die Erfindung betrifft ein Leitsystem für eine technische Anlage, insbesondere Fertigungs- oder Prozessanlage. Außerdem betrifft die Erfindung ein Verfahren zum Betrieb einer technischen Anlage, insbesondere Fertigungs- oder Prozessanlage, und ein Verfahren.

Bereiche eines Automatisierungsgerätes, welche High-Speed-Datenverbindungen (z.B. basierend auf Ethernet) verarbeiten, können eigensichere und nicht-eigensichere Schaltungsteile im Sinne des Explosionsschutzes aufweisen, wobei letztere mit der Zündschutzart "m" ausgeführt sind. Aus Gründen der Entwärmung kann es vorgesehen sein, dass eine als Flachbaugruppe(FBG) ausgebildetete Elektronikbaugruppe in einer Metallschale des Automatisierungsgerätes vergossen wird, über welche auch die Erdverbindung hergestellt wird. Die Highspeed-Verbindungen müssen dabei in und aus dem Vergussbereich und zu Anschlussteilen (beispielsweise einem Lichtwellenleiter-Transceiver) geführt werden.

Bekannte Lösungen verwenden meist Vergusstaschen aus Kunststoff, aus denen Bereiche der Elektronikbaugruppe herausragen und welche, in einer vertikalen Richtung angeordnet, verfüllt und anschließend im Gesamtgerät montiert werden müssen. Aus diesen Vergusstaschen werden die eingegossenen Leitungen herausgeführt oder vorgefertigte Vergussbaugruppen verwendet, aus denen Lötpins ragen, welche in einem Selektivlötprozess mit der der Elektronikbaugruppe verbunden werden.

Die EP 3 338 061 A1 offenbart ein Feldgerät und ein Bauteil zum Einfüllen einer Vergussmasse in das Feldgerät.

Der Erfindung liegt die Aufgabe zugrunde, ein Verfahren zum Herstellen eines Automatisierungsgerätes für eine technische Anlage anzugeben, welches die Anzahl an notwendigen Herstellungsschritten und die für das Automatisierungsgerät benötigten Komponenten verringert, wobei dennoch eine hohe Prozesssicherheit gewährleistet werden soll.

Diese Aufgabe wird gelöst durch ein Verfahren zum Herstellen eines Automatisierungsgerätes für eine technische Anlage, insbesondere Fertigungs- oder Prozessanlage, mit den Merkmalen des Anspruchs 1. Außerdem wird die Aufgabe gelöst durch ein Automatisierungsgerät nach Anspruch 11. Zudem wird die Aufgabe gelöst durch ein Leitsystem für eine technische Anlage nach Anspruch 12. Vorteilhafte Weiterbildungen ergeben sich aus den abhängigen Ansprüchen.

Ein erfindungsgemäßes Verfahren zum Herstellen eines Automatisierungsgerätes für eine technische Anlage, insbesondere Fertigungs- oder Prozessanlage, umfasst die folgenden Schritte:
a) Vorsehen eines ersten Teils einer Umhausung für das Automatisierungsgerät, wobei das erste Teil derart ausgebildet ist, dass ein erster Teilbereich und ein zweiter Teilbereich erzeugt ist,
b) Anordnen einer Elektronikbaugruppe in dem ersten Teil der Umhausung, wobei die Elektronikbaugruppe in dem ersten Teilbereich und in dem zweiten Teilbereich der Umhausung angeordnet wird, und wobei die Elektronikbaugruppe in dem zweiten Teilbereich Kommunikationsschnittstellen aufweist, die für eine Kommunikation des Automatisierungsgerätes mit externen Kommunikationspartnern vorgesehen und ausgebildet sind,
c) Vorsehen eines Trennelementes zwischen dem ersten Teilbereich und dem zweiten Teilbereich des ersten Teils der Umhausung,
d) Vergießen des ersten Teilbereichs des ersten Teils der Umhausung mit einer elektrisch isolierenden Vergussmasse, wobei das Trennelement eine horizontale Ausbreitung, orthogonal zu der Schwerkraft, der Vergussmasse verhindert,
e) Vorsehen eines zweiten Teils der Umhausung für das Automatisierungsgerät und Verbinden des zweiten Teils der Umhausung mit dem ersten Teil der Umhausung, um die vollständige Umhausung für das Automatisierungsgerät zu erzeugen.

Unter einer Automatisierung wird die selbständige (automatisierte) Erfassung und Beeinflussung physikalischer Größen mithilfe technischer Mittel verstanden. Dabei werden in der Regel Maschinen, Anlagen oder sonstige Einrichtungen in die Lage versetzt, selbsttätig zu arbeiten. Die Automatisierung umfasst wenigstens eine Parametrierung der Komponenten der Anlage und eine Interaktion der Komponenten mit weiteren Komponenten. Automatisierungsgeräte werden zur Realisierung einer Automatisierung benutzt und können beispielsweise speicherprogrammierbare Steuerungen oder Leitsysteme sein, die eine übergeordnete Steuerungsfunktion für untergeordnete speicherprogrammierbare Steuerungen darstellen.

Bevorzugt handelt es sich bei dem Automatisierungsgerät um einen Feldverteiler, welcher Schnittstellen zu unterlagerten Feldgeräten einer Prozessanlage oder einer Fertigungsanlage aufweist. Über diese Schnittstellen kann das Automatisierungsgerät Signale von den Feldgeräten empfangen oder an diese übermitteln.

Bei der technischen Anlage kann es sich um eine Anlage aus der Prozessindustrie wie beispielsweise eine chemische, pharmazeutische, petrochemische oder eine Anlage aus der Nahrungs- und Genussmittelindustrie handeln. Hiermit umfasst sind auch jegliche Anlagen aus der Produktionsindustrie, Werke, in denen z.B. Autos oder Güter aller Art produziert werden. Technische Anlagen, die zur Durchführung des erfindungsgemäßen Verfahrens geeignet sind, können auch aus dem Bereich der Energieerzeugung kommen. Windräder, Solaranlagen oder Kraftwerke zur Energieerzeugung sind ebenso von dem Begriff der technischen Anlage umfasst.

Unter einem Leitsystem wird im vorliegenden Kontext ein computergestütztes, technisches System verstanden, das Funktionalitäten zum Darstellen, Bedienen und Leiten der technischen Anlage umfasst. Das Leitsystem kann auch Sensoren zur Ermittlung von Messwerten sowie verschiedene Aktoren umfassen. Zudem kann das Leitsystem sogenannte prozess- oder fertigungsnahe Komponenten umfassen, die zur Ansteuerung der Aktoren bzw. Sensoren dienen. Darüber hinaus kann das Leitsystem u.a. Mittel zur Visualisierung der verfahrenstechnischen Anlage und zu einem Engineering aufweisen. Das Leitsystem kann optional auch weitere Recheneinheiten für komplexere Regelungen und Systeme zur Datenspeicherung und -verarbeitung umfassen.

Das Automatisierungsgerät weist eine Umhausung auf, die bevorzugt aus einem Kunststoff oder einem Metall gefertigt ist. Höchst vorzugsweise ist die Umhausung aus Aluminium gefertigt worden. Die im Vorhinein bereits gefertigte Umhausung (anders ausgedrückt: das Gehäuse) wird bei dem erfindungsgemäßen Verfahren im Gegensatz zu bekannten Verfahren direkt als Verschalung für die Vergussmasse verwendet, indem der erste Teil der Umhausung, in welchen die Elektronikbaugruppe gegeben wird, mit der Vergussmasse verfüllt wird. Dadurch entfällt auf der einen Seite die Notwendigkeit einer zusätzlichen Verschalung. Auf der anderen Seite wird die Entwärmung der Elektronikbauelemente der Elektronikbaugruppe verbessert, da die Wärme über die Vergussmasse direkt an die Umhausung geleitet werden kann.

Die Elektronikbaugruppe kann eine mit Elektronikbauelementen wie Widerständen, Dioden, Induktivitäten, Kondensatoren, Operationsverstärkern oder Transistoren bestückte Leiterplatte sein. Die Leiterplatte dient dabei als Träger für die Elektronikbauelemente und stellt die mechanischen Befestigungen und die elektrischen Verbindungen zwischen den Elektronikbauelementen bereit.

Es wurde erkannt, dass wenigstens der Teil der Kommunikationsschnittstellen der Elektronikbaugruppe (der zweite Teilbereich) zwar eigensicher bzw. explosionsgeschützt ausgebildet, aber nicht von der Vergussmasse umgeben sein muss. Daher wird erfindungsgemäß vor dem Verfüllen mit der Vergussmasse ein Trennelement vorgesehen, welches bewirkt, dass die Vergussmasse nur einen Anteil der Elektronikbaugruppe (den ersten Teilbereich) umgibt. Die Verfüllung mit der Vergussmasse findet dabei in einer horizontalen Lage der Umhausung bzw. der Elektronikbaugruppe statt. Dies bedeutet mit anderen Worten, dass das Trennelement verhindert, dass die einfließende Vergussmasse von dem ersten Teilbereich, orthogonal zu der Schwerkraft, also "horizontal", auch in den zweiten Teilbereich fließt. Das Trennelement stellt damit keine Begrenzung der Füllhöhe der Vergussmasse dar, sondern eine seitliche Barriere, um ein Übergreifen der Vergussmasse in den zweiten Teilbereich mit den (Highspeed-)Kommunikationsschnittstellen zu verhindern.

Die Vergussmasse selbst weist eine elektrisch isolierende Eigenschaft auf. Dabei weist sie gleichzeitig eine ausreichend hohe thermische Leitfähigkeit auf. Als Vergussmasse kann ein Kunststoff, beispielsweise Polyurethan, ein Epoxidharz, ein 2-Komponenten Gießharz, ein Silikongel und/oder eine Silikonmasse zum Einsatz kommen.

Das erfindungsgemäße Verfahren ermöglicht ein Minimum an Fertigungsschritten und Komponenten zur Herstellung des zweiten Teilbereichs der Elektronikbaugruppe mit der hier diesen umgebenden Umhausung, sowie eine Reduzierung der Toleranzkette im Gesamtaufbau des Automatisierungsgeräts. Das Verfahren ermöglicht insgesamt eine prozesssichere und kostengünstige Herstellung bei einer gesteigerten Entwärmung der Elektronikkomponenten im ersten Teilbereich.

Im Rahmen einer vorteilhaften Weiterbildung der Erfindung ist wenigstens ein Teil der im zweiten Teilbereich der Elektronikbaugruppe angeordneten Kommunikationsschnittstellen dazu ausgebildet, die Kommunikation des Automatisierungsgerätes mit externen Kommunikationspartnern auf Basis von Ethernet und der TCP/IP-Protokollgruppe durchzuführen. Es handelt sich demnach bei den Kommunikationsschnittstellen um "Highspeed"-Kommunikationsschnittstellen, über die das Automatisierungsgerät mit den externen Kommunikationspartner wie einem Operator Station Server des Leitsystems für die technische Anlage kommunizieren kann.

Bevorzugt handelt es sich bei dem Trennelement um eine Trennplatte, die nach dem Anordnen der Elektronikbaugruppe in eine Führung geführt wird, um den ersten Teilbereich und den zweiten Teilbereich des ersten Teils der Umhausung für das Vergießen mit der Vergussmasse voneinander zu trennen. Diese Trennplatte kann in eine umlaufende Nut eingeführt werden, die mit einer speziellen Abdichtung versiegelt wird, um ein Eindringen der Vergussmasse in den zweiten Teilbereich zu verhindern.

Um die mechanische Stabilität zu verbessern, kann die die Elektronikbaugruppe vor dem Vergießen mit der Vergussmasse mit dem ersten Teil der Umhausung verbunden werden, insbesondere durch ein Verschrauben.

Besonders bevorzugt wird nach dem Vorsehen des Trennelementes die Elektronikbaugruppe in dem ersten Teilbereich des ersten Teils der Umhausung mit einem Deckelement, insbesondere einer flächigen Abdeckplatte, abgedeckt, wobei in dem Deckelement wenigstens eine Öffnung zum Eintritt der Vergussmasse vorgesehen ist. Es können mehrere Öffnungen vorgesehen sein, um den gleichmäßigen Eintritt der Vergussmasse zu erleichtern. Der Schritt des Verfüllens kann unter Vorherrschen einer Unterdruckatmosphäre durchgeführt werden, um etwaige Lufteinschlüsse in der Vergussmasse zu vermeiden.

Zur Fixierung des Deckelementes und zur erleichterten Vorgabe einer bestimmten Füllhöhe der Vergussmasse kann das Deckelement mit der Elektronikbaugruppe, ggf. auch zusätzlich mit der Umhausung, verbunden werden, insbesondere durch ein Verschrauben.

Die zuvor formulierte Aufgabe wird gleichsam gelöst durch ein Automatisierungsgerät, das unter Durchführung eines zuvor beschriebenen Verfahrens hergestellt worden ist.

Außerdem wird die Aufgabe gelöst durch ein Leitsystem für eine technische Anlage, insbesondere Fertigungs- oder Prozessanlage, welches wenigstens einen Operator Station Server zur Bedienung und Beobachtung der technischen Anlage und ein Automatisierungsgerät wie zuvor beschrieben umfasst.

Unter einem "Operator Station Server" wird vorliegend ein Server verstanden, der zentral Daten eines Bedien- und Beobachtungssystems sowie in der Regel Alarm- und Messwertarchive eines Leitsystems einer technischen Anlage erfasst und Benutzern zur Verfügung stellt. Der Operator Station Server stellt in der Regel eine Kommunikationsverbindung zu Automatisierungssystemen der technischen Anlage her und gibt Daten der technischen Anlage an sogenannte Operator Station Clients weiter, die zur Bedienung und Beobachtung eines Betriebs der einzelnen Funktionselemente der technischen Anlage dienen. Der Operator Station Server kann über Client-Funktionen verfügen, um auf die Daten (Archive, Meldungen, Tags, Variablen) anderer Operator Station Server zuzugreifen. Dadurch sind Bilder eines Betriebs der technischen Anlage auf dem Operator Station Server mit Variablen anderer Operator Station Server (Server-Server-Kommunikation) kombinierbar. Bei dem Operator Station Server kann es sich, ohne sich darauf zu beschränken, um einen SIMATIC PCS 7 Industrial Workstation Server der Firma SIEMENS handeln.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Es zeigen:
- FIG 1: einen ersten Schritt eines erfindungsgemäßen Verfahrens;
- FIG 2: einen zweiten Schritt eines erfindungsgemäßen Verfahrens;
- FIG 3: einen dritten Schritt eines erfindungsgemäßen Verfahrens;
- FIG 4: einen vierten Schritt eines erfindungsgemäßen Verfahrens;
- FIG 5: einen fünften Schritt eines erfindungsgemäßen Verfahrens;
- FIG 6: einen sechsten Schritt eines erfindungsgemäßen Verfahrens; und
- FIG 7: einen siebten Schritt eines erfindungsgemäßen Verfahrens.

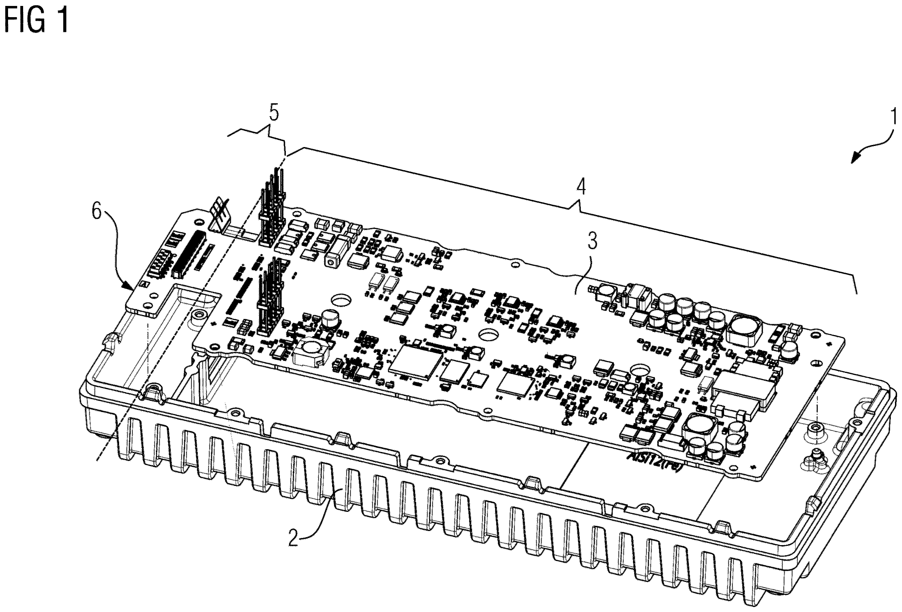

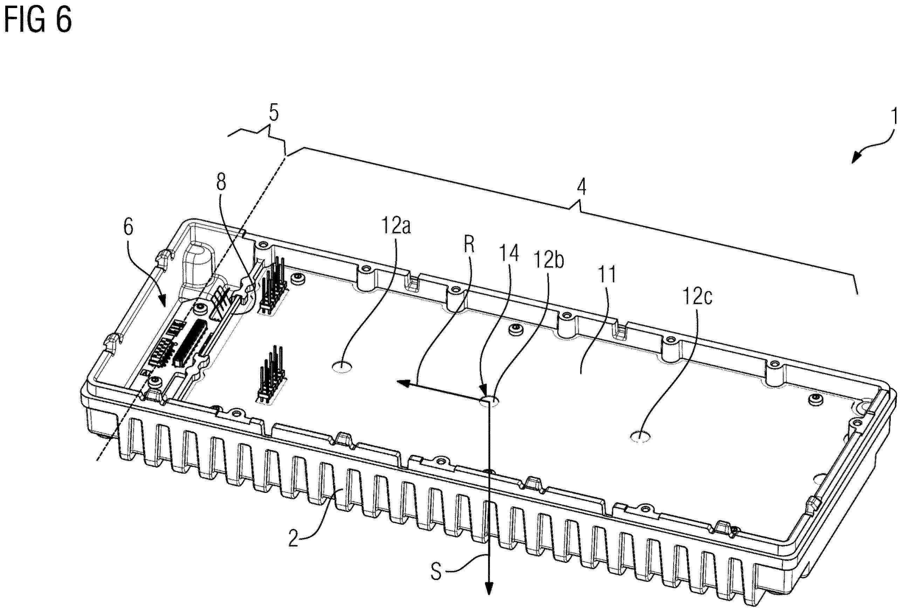

Im Folgenden wird ein erfindungsgemäßes Verfahren zur Herstellung eines Automatisierungsgerätes 1 anhand der Figuren 1 bis 7 erläutert. Es wird zunächst davon ausgegangen, dass ein erster Teil 2 einer Umhausung im Vorhinein bereits aus Aluminium gefertigt worden ist. Eine ebenfalls bereits gefertigte Elektronikbaugruppe 3 ist als mit Elektronikbauelementen bestückte Leiterplatte bzw. als Flachbaugruppe (FBG) ausgebildet. Der erste Teil 1 der Umhausung 2 für die Elektronikbaugruppe 3 ist derart hergestellt worden, dass er einen ersten Teilbereich 4 und einen zweiten Teilbereich 5 aufweist. Die Elektronikbaugruppe 3 wird in den ersten Teil 1 der Umhausung 2 eingeführt, wobei die Elektronikbaugruppe 3 sowohl in dem ersten Teilbereich 4 als auch in dem zweiten Teilbereich 5 angeordnet ist. In FIG 1 ist zu erkennen, dass sich die Elektronikbaugruppe 3 von dem ersten Teilbereich 4 bis in den zweiten Teilbereich 5 erstreckt, wenn sie in den ersten (unteren) Teil 2 der Umhausung eingelegt ist. Die Elektronikbaugruppe 3 weist Kommunikationsschnittstellen 6 auf, die sich in dem zweiten Teilbereich 5 des ersten Teils 2 der Umhausung befinden, wenn die Elektronikbaugruppe 3 in den zweiten Teil 2 der Umhausung eingeführt ist. Die Kommunikationsschnittstellen 6 sind dazu ausgebildet, die Kommunikation des Automatisierungsgerätes 1 mit externen Kommunikationspartnern auf Basis von Ethernet und der TCP/IP-Protokollgruppe durchzuführen.

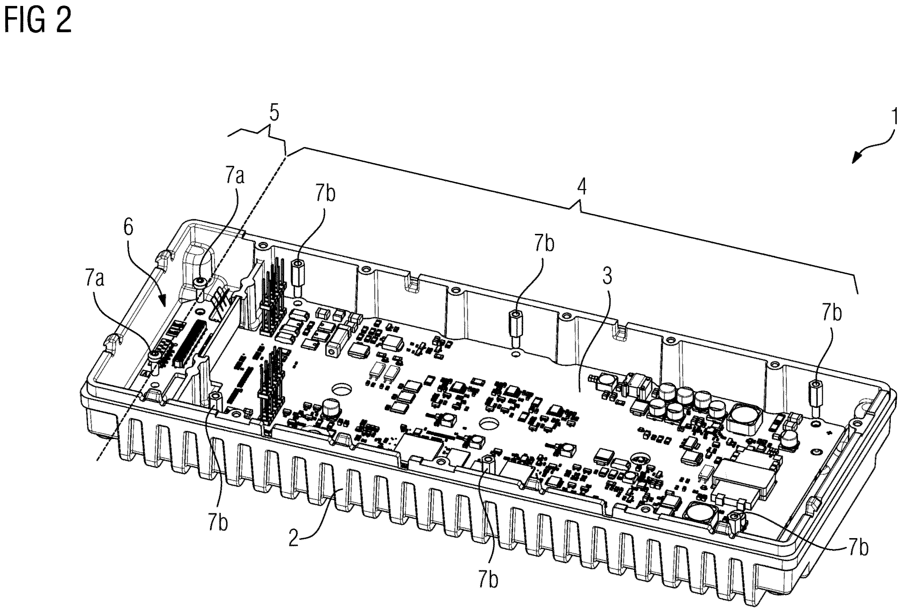

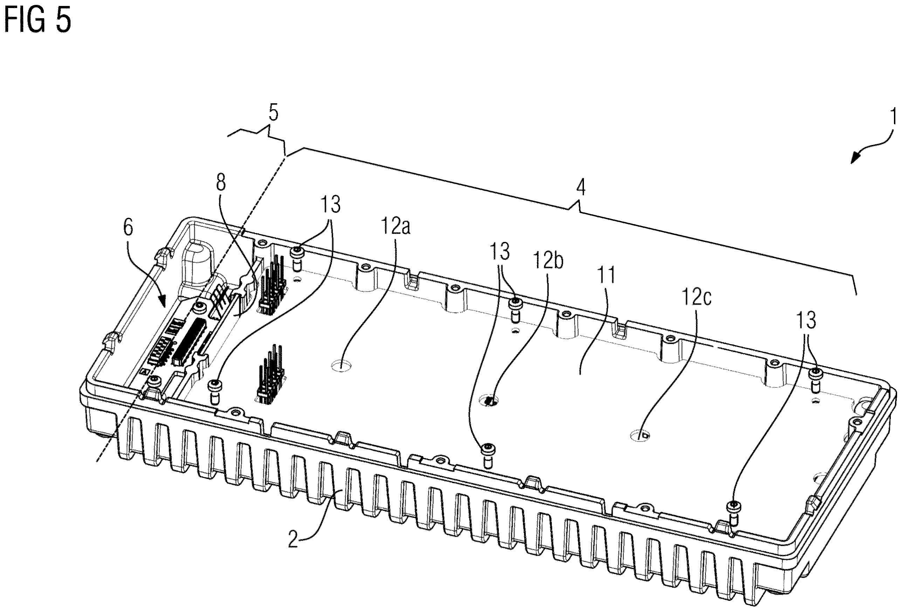

In FIG 2 ist zu erkennen, dass die Elektronikbaugruppe 3 nach dem Einsetzen in den ersten Teil 2 der Umhausung mit der Umhausung verschraubt wird. Hierzu wird die Elektronikbaugruppe 3 in dem zweiten Teilbereich 5 mit Schrauben 7a an der Umhausung befestigt. In dem ersten Teilbereich 4 sind die befestigenden Schrauben 7b zusätzlich als Abstandselemente ausgebildet (vgl. FIG 5).

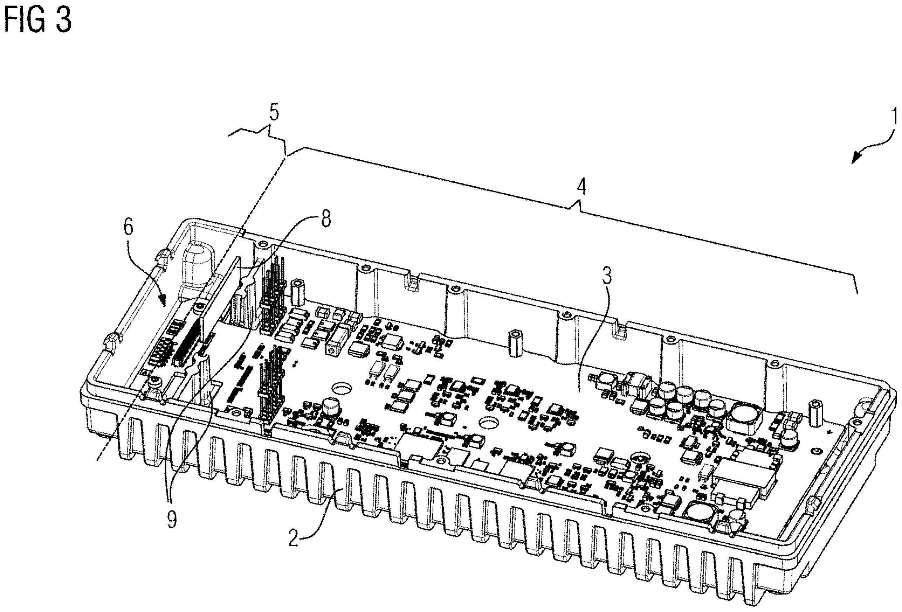

In FIG 3 ist dargestellt, dass ein als Trennplatte ausgebildetes Trennelement 8 zwischen dem ersten Teilbereich 4 und dem zweiten Teilbereich 5 vorgesehen wird. Das Trennelement 8 wird nach dem Anordnen der Elektronikbaugruppe 3 in eine Führung 9 geführt, um den ersten Teilbereich 4 und den zweiten Teilbereich 5 des ersten Teils 2 der Umhausung für das Vergießen mit der Vergussmasse voneinander zu trennen.

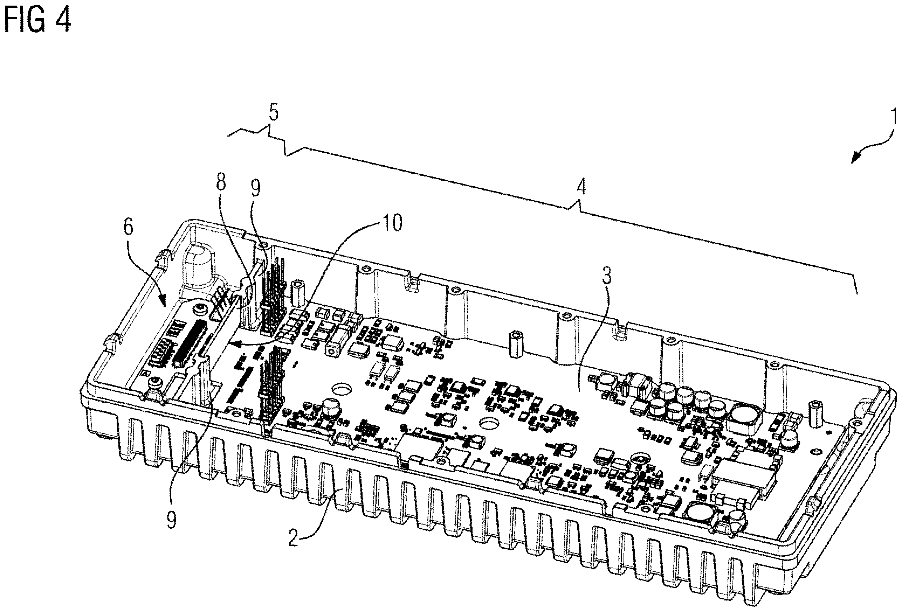

Das Trennelement 8 wird entlang der Führung 9 und in einem Kontaktbereich 10 mit der Elektronikbaugruppe 3 mit einer dichtenden Masse umgeben, um die Dichtwirkung weiter zu verbessern. Diese dichtende Masse kann auch bereits vor dem Einsetzen der Elektronikbaugruppe 3 entlang der Führung 9 verteilt worden sein. Das in die Führung 9 eingeführte Trennelement 8 zeigt FIG 4.

In dem ersten Teilbereich 4 des ersten Teils 2 der Umhausung wird über der Elektronikbaugruppe 3 ein als flächige Abdeckplatte ausgebildetes Deckelement 11 angeordnet. In dem Deckelement 11 befinden sich drei Öffnungen 12a, 12b, 12c. Das Deckelement 11 wird mittels Schrauben 13 mit der Elektronikbaugruppe 3 verbunden. Dabei greifen die Schrauben 13 in die entsprechenden Schrauben 7b (vgl. FIG 2) ein, welche somit als Abstandselemente zwischen Elektronikbaugruppe 3 und Deckelement 11 fungieren.

In einer Unterdruckatmosphäre wird eine als Zweikomponenten-Polyurethanmasse ausgebildete Vergussmasse 14 in die mittlere Öffnung 12b des Deckelementes 11 gegossen, um den Hohlraum zwischen der Elektronikbaugruppe 3 und dem Deckelement 11 mit der elektrisch isolierenden Zweikomponenten-Polyurethanmasse zu verfüllen und um die Elektronikbaugruppe 3 in dem ersten Teilbereich 4 nach der Verkapselung mit der Vergussmasse gemäß Ex-m zu schützen. Es ist zu erkennen, dass das Trennelement 8 eine horizontale Ausbreitung, in einer Richtung R orthogonal zu einer Richtung S der Schwerkraft, der Vergussmasse 14 verhindert.

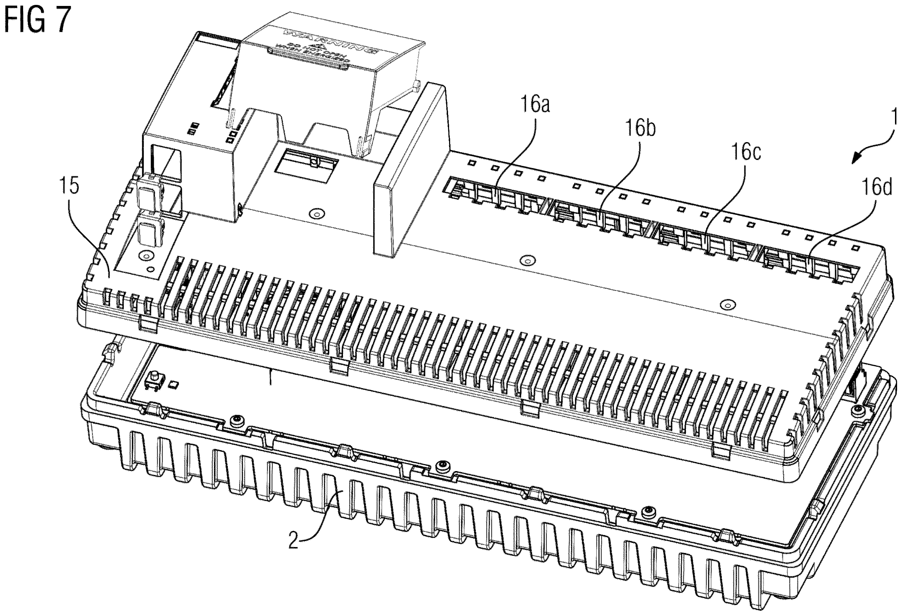

FIG 7 zeigt, wie ein zweiter Teil 15 final auf den ersten, unteren Teil 2 der Umhausung gesetzt und mit diesem verbunden wird (zum Beispiel durch ein Einrasten entsprechender Rastnasen). Dabei wird u.a. eine Transceiver-Leiterplatte vertikal gesteckt und mit den äußeren Anschlüssen montiert. Das entstandene Automatisierungsgerät 1 ist vorliegend als ein Feldverteiler ausgebildet, welcher Schnittstellen 16a, 16b, 16c, 16d zu unterlagerten Feldgeräten einer Prozessanlage oder einer Fertigungsanlage aufweist.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Herstellen eines Automatisierungsgerätes (1) für eine technische Anlage, insbesondere Fertigungs- oder Prozessanlage, umfassend:
a) Vorsehen eines ersten Teils (2) einer Umhausung für das Automatisierungsgerät (1), wobei der erste Teil (2) derart ausgebildet ist, dass ein erster Teilbereich (4) und ein zweiter Teilbereich (5) erzeugt ist,
b) Anordnen einer Elektronikbaugruppe (3) in dem ersten Teil (2) der Umhausung, wobei die Elektronikbaugruppe (3) in dem ersten Teilbereich (4) und in dem zweiten Teilbereich (5) der Umhausung angeordnet wird, und wobei die Elektronikbaugruppe (3) nach dem Anordnen in dem zweiten Teilbereich (5) Kommunikationsschnittstellen (6) aufweist, die für eine Kommunikation des Automatisierungsgerätes (1) mit externen Kommunikationspartnern vorgesehen und ausgebildet sind,
c) Vorsehen eines Trennelementes (8) zwischen dem ersten Teilbereich (4) und dem zweiten Teilbereich (5) des ersten Teils (2) der Umhausung,
d) Vergießen des ersten Teilbereichs (4) des ersten Teils (2) der Umhausung mit einer elektrisch isolierenden Vergussmasse (14), wobei das Trennelement (8) eine horizontale Ausbreitung, orthogonal zu der Schwerkraft, der Vergussmasse (14) verhindert,
e) Vorsehen eines zweiten Teils (15) der Umhausung für das Automatisierungsgerät (1) und Verbinden des zweiten Teils (15) der Umhausung mit dem ersten Teil (2) der Umhausung, um die vollständige Umhausung für das Automatisierungsgerät (1) zu erzeugen.

2. Verfahren nach Anspruch 1, bei dem als elektrisch isolierende Vergussmasse (14) ein Kunststoff, insbesondere Polyurethan, ein Epoxidharz, ein 2-Komponenten Gießharz, ein Silikongel und/oder eine Silikonmasse verwendet wird.

3. Verfahren nach Anspruch 1 oder 2, bei dem die Umhausung aus einem Kunststoff oder einem Metall gefertigt wird, insbesondere aus Aluminium.

4. Verfahren nach einem der vorangegangenen Ansprüche, bei dem das Automatisierungsgerät (1) ein Feldverteiler ist, welcher Schnittstellen (16a, 16b, 16c, 16d) zu unterlagerten Feldgeräten einer Prozessanlage oder einer Fertigungsanlage aufweist.

5. Verfahren nach einem der vorangegangenen Ansprüche, bei dem wenigstens ein Teil der im zweiten Teilbereich (5) der Elektronikbaugruppe (3) angeordneten Kommunikationsschnittstellen (6) dazu ausgebildet ist, die Kommunikation des Automatisierungsgerätes (1) mit externen Kommunikationspartnern auf Basis von Ethernet und der TCP/IP-Protokollgruppe durchzuführen.

6. Verfahren nach einem der vorangegangenen Ansprüche, bei dem es sich bei der Elektronikbaugruppe (3) um eine mit Elektronikbauelementen bestückte Leiterplatte handelt.

7. Verfahren nach einem der vorangegangenen Ansprüche, bei dem es sich bei dem Trennelement (8) um eine Trennplatte handelt, die nach dem Anordnen der Elektronikbaugruppe (3) in eine Führung (9) geführt wird, um den ersten Teilbereich (4) und den zweiten Teilbereich (5) des ersten Teils (2) der Umhausung für das Vergießen mit der Vergussmasse (14) voneinander zu trennen.

8. Verfahren nach einem der vorangegangenen Ansprüche, bei dem die Elektronikbaugruppe (3) vor dem Vergießen mit der Vergussmasse (14) mit dem ersten Teil (2) der Umhausung verbunden wird, insbesondere durch ein Verschrauben.

9. Verfahren nach einem der vorangegangenen Ansprüche, bei dem nach dem Vorsehen des Trennelementes (8) die Elektronikbaugruppe (3) in dem ersten Teilbereich (4) des ersten Teils (2) der Umhausung mit einem Deckelement (11), insbesondere einer flächigen Abdeckplatte, abgedeckt wird, wobei in dem Deckelement (11) wenigstens eine Öffnung (12a, 12b, 12c) zum Eintritt der Vergussmasse (14) vorgesehen ist.

10. Verfahren nach Anspruch 9, bei dem das Deckelement (11) mit der Elektronikbaugruppe (3) verbunden wird, insbesondere durch ein Verschrauben.

11. Automatisierungsgerät (1), das unter Durchführung eines Verfahrens gemäß einem der vorangegangenen Ansprüche hergestellt worden ist.

12. Leitsystem für eine technische Anlage, insbesondere Fertigungs- oder Prozessanlage, welches wenigstens einen Operator Station Server zur Bedienung und Beobachtung der technischen Anlage und ein Automatisierungsgerät (1) gemäß Anspruch 11 umfasst.
